# EUROPÄISCHE PATENTSCHRIFT

(11) **EP 4 189 357 B1**
(45) Veröffentlichungstag und Bekanntmachung des Hinweises auf die Patenterteilung: **12.11.2025**
(21) Anmeldenummer: 21748777.6
(22) Anmeldetag: 13.07.2021
(51) Int. Cl.: G01M 17/06, G01R 31/00

(54) **PRÜFSTAND FÜR EIN KRAFTFAHRZEUG UND VERFAHREN ZUM DURCHFÜHREN EINER KRAFTFAHRZEUGPRÜFUNG**
TEST BENCH FOR A MOTOR VEHICLE AND METHOD FOR PERFORMING A MOTOR-VEHICLE TEST
BANC D'ESSAI POUR VÉHICULE AUTOMOBILE ET PROCÉDÉ POUR RÉALISER UN CONTRÔLE SUR UN VÉHICULE AUTOMOBILE

(30) Priorität: 30.07.2020 DE 102020120166
(43) Veröffentlichungstag der Anmeldung: 07.06.2023
(73) Patentinhaber: SHI Maschinen GmbH, 92699 Bechtsrieth (DE)
(72) Erfinder: HUELLMANDEL, Steven, 92699 Bechtsrieth (DE)
(74) Vertreter: Benninger, Johannes
(86) Internationale Anmeldenummer: PCT/EP2021/069417
(87) Internationale Veröffentlichungsnummer: WO 2022/023018

(56) Entgegenhaltungen:
- EP-A1- 2 602 602
- CN-A- 110 187 139
- DE-A1- 102010 016 587
- DE-A1- 3 507 906
- JP-A- 2016 061 668

## Beschreibung

Die vorliegende Erfindung betrifft einen Prüfstand für ein Kraftfahrzeug, ein Prüfrad sowie ein Verfahren zum Durchführen einer Kraftfahrzeugprüfung.

Um diverse Funktionen von Fahrzeugen überprüfen zu können, werden diese im Stand der Technik auf einem Prüfstand angeordnet, wobei ein solcher Prüfstand in der Regel ein Rollenpaar besitzt, auf welchem Rollenpaar das jeweilige zu prüfende Fahrzeug mit seinen angetriebenen Rädern aufsteht. Die angetriebenen Räder des Kraftfahrzeuges können sodann ihre drehende Bewegung auf das Rollenpaar des Prüfstandes übertragen.

Die jeweiligen nicht angetriebenen Räder des jeweiligen Fahrzeuges stehen hierbei auf einer Bodenfläche auf. Sofern die nicht angetriebenen Räder stillstehen, kann davon ausgegangen werden, dass die angetriebenen Räder auf dem Rollenpaar verbleiben und das jeweilige Fahrzeug nicht ungewollt aus dem Rollenpaar austritt. Um ein solches Risiko weiter reduzieren zu können, existieren im Stand der Technik zudem Möglichkeiten, mittels welchen das Fahrzeug zusätzlich auf dem Rollenprüfstand fixiert werden kann. So offenbart beispielsweise das deutsche Gebrauchsmuster DE 298 15 234 U1 eine Vorrichtung zur Fesselung von Fahrzeugen auf einem Rollenprüfstand. Bei der aus dem DE-Gebrauchsmuster bekannten Vorrichtung stütz sich ein Vorderrad des Fahrzeuges auf einer drehangetriebenen Rolle ab. Die Vorderachse wird hierbei über zwei Stützholme fixiert, die sich schräg im Raum erstrecken und mit ihren unteren Enden über je ein Gelenk auf einem Bodenfundament verankert sind.

Um Betriebsbedingungen zu simulieren, welche mit einem tatsächlichen Fahren des Fahrzeuges vergleichbar sind, kann es in der Praxis notwendig sein, sowohl die Vorderräder als auch die Hinterräder des Fahrzeuges jeweils drehend zu bewegen. Zum Überprüfen diverser Funktionen kann es sein, dass das Fahrzeug beispielsweise gelenkt werden muss oder dass die Vorderräder und die Hinterräder jeweils derart angetrieben werden müssen, dass ein ggf. als Bestandteil des Fahrzeuges ausgebildetes elektronisches Steuer- und/oder Regelsystem diese Bewegung als Betrieb bzw. Fahrtbewegung des Fahrzeuges erkennt. Bei den aus dem Stand der Technik bekannten Prüfständen besteht das Problem, dass ein Fahrzeug bei einer Lenkbewegung der Vorderräder das Rollenpaar ggf. ungewollt verlässt.

Aus der DE 10 2016 016 587 A1 ist ein Radsatz zur Erprobung eines Kraftfahrzeugs bei stillstehenden Reifen offenbart, welcher eine Felge und eine Nabe aufweist, die koaxial zueinander angeordnet und drehbar miteinander verbunden sind. Die Nabe wirkt mit einem Adapterelement zusammen, das eine Adapterplatte und einen Wellenstumpf aufweist, der zentrisch an einer Stirnseite der Adapterplatte angeordnet ist.

Aus der DE 3507906 A1 ist eine Hilfseinrichtung für Kraftfahrzeug-Prüfstände bekannt. Anstelle der normalen Räder wird ein Hilfsrad an das Fahrzeug angebracht. Über eine schwimmende Radauflagerung können Längs- und Querkräfte sowie Drehmomente um eine Vertikalachse des Rades in beliebiger Kombination in das Rad eingeleitet und entsprechende Reaktionen am Fahrzeug beobachtet werden.

Die EP 2 602 602 A1 offenbart zudem einen Fahrzeugprüfstand. Über Beaufschlagungseinheiten werden Prüflasten an Prüfrädern des Fahrzeugs simuliert, während gleichzeitig die Prüfräder über ein Antriebsaggregat entsprechend der Antriebsdrehzahl im Fahrbetrieb angetrieben werden.

Eine Aufgabe der Erfindung kann darin gesehen werden, eine gegenüber dem Stand der Technik verbesserte Möglichkeit zur Überprüfung diverser Funktionen eines Kraftfahrzeuges bereitzustellen.

Die obige Aufgabe wird durch die Gegenstände gelöst, welche die Merkmale in den unabhängigen Ansprüchen umfassen. Vorteilhafte Ausführungsformen werden durch die abhängigen Ansprüche beschrieben.

Die Erfindung betrifft ein Prüfrad für ein Kraftfahrzeug mit einer Radfelge und einer Radnabe, welche Radnabe zur Befestigung an einem Radträger eines Kraftfahrzeuges ausgebildet ist. Die Radnabe steht derart mit der Radfelge des Prüfrades in Verbindung, dass die Radnabe bei stehendem Prüfrad relativ zur Radfelge um eine aufrechte und vorzugsweise vertikal orientierte Achse gedreht werden kann. Ergänzend hierzu kann es sein, dass die Radnabe derart mit einer Radfelge des Prüfrades in Verbindung steht, dass die Radnabe bei stehendem Prüfrad relativ zur Radfelge um eine horizontal orientierte Achse rotieren kann, wobei die Radnabe mit einer Welle eines als Bestandteil eines Prüfstandes ausgebildeten Antriebsmotors verbindbar ist. An der Radfelge des Prüfrades kann ggf. ein Radmantel angeordnet sein.

Es kann sein, dass die Radnabe mehrere Öffnungen besitzt, durch welche Schraubverbindungen zur Befestigung der Radnabe des Prüfrades an einem Radträger eines Kraftfahrzeuges geführt werden können.

In bevorzugten Ausführungsformen kann es sein, dass die Radnabe über ein Gleitoder Wälzlager derart mit der Radfelge in Verbindung steht, dass die Radnabe bei stehendem Prüfrad relativ zur Radfelge um eine aufrechte und vorzugsweise vertikal orientierte Achse gedreht werden kann. Zudem kann es hierbei sein, dass die Radnabe über das Gleit- oder Wälzlager derart mit der Radfelge in Verbindung steht, dass die Radnabe bei stehendem Prüfrad relativ zur Radfelge um eine horizontal orientierte Achse rotieren kann, wobei die Radnabe mit einer Welle eines als Bestandteil eines Prüfstandes ausgebildeten Antriebsmotors verbindbar ist.

In der Praxis haben sich hierbei Ausführungsformen bewährt, bei welchen die Radnabe über ein Wälzlager derart mit der Radfelge in Verbindung steht, dass die Radnabe bei stehendem Prüfrad relativ zur Radfelge um eine aufrechte und vorzugsweise vertikal orientierte Achse gedreht werden kann. Wälzlager bieten gegenüber weiteren Lagern bei solchen Ausgestaltungen den Vorteil, dass die Radfelge relativ zum Radlager um die aufrechte und vorzugsweise vertikal orientierte Achse gedreht werden kann, ohne dass hierbei ein großes Widerstandsmoment die Drehbewegung beeinflusst. Mittels solcher Wälzlager wird somit ein spannungsarmes bzw. spannungsfreies Drehen der Radnabe gegenüber der Radfelge ermöglicht. Diese Drehbewegung mit geringem Widerstandsmoment entspricht im Wesentlichen dem Verhalten des Kraftfahrzeuges bei einer Lenkbewegung im Verlauf einer tatsächlichen Fortbewegung bzw. Straßenfahrt. Eine Lenkbewegung lässt sich somit sehr genau simulieren, sofern die Radnabe über ein Wälzlager mit der Radfelge derart in Verbindung steht, dass die Radnabe bei stehendem Prüfrad relativ zur Radfelge um eine aufrechte und vorzugsweise vertikal orientierte Achse gedreht werden kann.

Bewährt hat es sich, wenn die Radnabe über ein Wälzlager, das einen Freiheitsgrad f=3 besitzt, derart mit der Radfelge in Verbindung steht, dass die Radnabe bei stehendem Prüfrad relativ zur Radfelge um eine aufrechte und vorzugsweise vertikal orientierte Achse gedreht werden kann. Alternativ oder ergänzend hierzu kann es sein, dass die Radnabe über das Wälzlager, welches einen Freiheitsgrad von f=3 besitzt, derart mit der Radfelge in Verbindung steht, dass die Radnabe bei stehendem Prüfrad relativ zur Radfelge um eine horizontal orientierte Achse rotieren kann, wobei die Radnabe mit einer Welle eines als Bestandteil eines Prüfstandes ausgebildeten Antriebsmotors verbindbar ist.

Auch betrifft die Erfindung einen Prüfstand für Kraftfahrzeuge. Der Prüfstand umfasst ein Prüfrad gemäß einem Ausführungsbeispiel der vorhergehenden Beschreibung, welches Prüfrad über seine Radnabe an einem Radträger eines Kraftfahrzeuges befestigt werden kann. Insbesondere kann der Prüfstand für Kraftfahrzeuge als Prüfstand für Automobile ausgebildet sein. Ein solches Automobil kann genau zwei Vorderräder und genau zwei Hinterräder umfassen.

Zudem umfasst der Prüfstand wenigstens einen Antriebsmotor mit einer Welle, welche Welle mit der Radnabe des Prüfrades verbindbar ist und welche Welle die Radnabe des Prüfrades rotierend antreiben kann. Der wenigstens eine Antriebsmotor kann durch wenigstens einen Elektromotor ausgebildet sein.

Es kann sein, dass die Welle des wenigstens einen Antriebsmotors und die Radnabe derart ausgebildet sind bzw. dass die Welle des wenigstens einen Antriebsmotors und die Radnabe derart miteinander korrespondieren, dass die Welle des wenigstens einen Antriebsmotors mit der Radnabe des Prüfrades über Schraubverbindungen verbunden werden kann.

Es kann sein, dass die Welle als Kardangelenkwelle ausgebildet ist. Auch hat es sich bewährt, wenn der Prüfstand ein zum Abschirmen gegen elektromagnetische Strahlung ausgebildetes Gehäuse besitzt, in welchem zum Abschirmen gegen elektromagnetische Strahlung ausgebildeten Gehäuse der Antriebsmotor aufgenommen ist. Solche Ausführungsformen haben sich insbesondere bewährt, sofern Funktionen des Kraftfahrzeuges im Hinblick auf eine Beeinflussung über elektromagnetische Störgrößen geprüft werden sollen. Von dem ggf. im Gehäuse aufgenommenen Antriebsmotor können hierdurch keine Störgrößen ausgehen, welche ein Prüf- bzw. Messergebnis ggf. verfälschen. Auch kann eine über das zu prüfende Fahrzeug ggf. abgegebene elektromagnetische Strahlung bei solchen Ausführungsformen die Arbeitsweise des Antriebsmotors nicht beeinflussen. In der Praxis ist es wichtig, dass elektronische Komponenten in einem Fahrzeug eine nach Möglichkeit gering ausgebildete Anfälligkeit für Störungen besitzen, die durch elektromagnetische Strahlung verursacht werden können. Eine Eigenschaft eines solchen Kraftfahrzeuges elektromagnetischer Strahlung standzuhalten, wird als Störfestigkeit bezeichnet. Zudem besitzt jedes Fahrzeug ein gewisses Maß an Störausstrahlung, womit die Eigenschaft eines jeweiligen Fahrzeuges gemeint ist, elektromagnetische Strahlung abzugeben. Sowohl die Störanfälligkeit als auch die Störausstrahlung eines jeweiligen Fahrzeuges sollen nach Möglichkeit gering gehalten werden.

Bewährt hat es sich beispielsweise, wenn das zum Abschirmen gegen elektromagnetische Strahlung ausgebildete Gehäuse aus Metall ausgebildet ist oder wenn das zum Abschirmen gegen elektromagnetische Strahlung ausgebildete Gehäuse eine Metallfolie umfasst, welche auf eine Innenwand des zum Abschirmen gegen elektromagnetische Strahlung ausgebildeten Gehäuses aufgebracht ist.

Zudem haben sich Ausführungsformen bewährt, bei welchen der wenigstens eine Antriebsmotor in ein elektromagnetische Strahlung absorbierendes Material eingebettet ist. Auch bei solchen Ausführungsformen wird eine zuverlässige Arbeitsweise des Antriebsmotors durch ggf. über das jeweilige zu prüfende Fahrzeug abgegebene elektromagnetische Strahlung nicht beeinflusst. Zudem wird die Funktionsweise des jeweiligen Fahrzeuges im Verlauf einer Prüfung auf Störfestigkeit bzw. auf elektromagnetische Verträglichkeit bei solchen Ausführungsformen nicht durch elektromagnetische Strahlung beeinflusst, welche ggf. über den wenigstens einen Antriebsmotor abgegeben wird.

In weiteren Ausführungsformen kann es sein, dass die Welle als biegeelastische Welle ausgebildet ist. Auch bei solchen Ausführungsformen kann die Welle selbst dann mit der Radnabe des Prüfrades verbunden werden, wenn sich der die Welle ausbildende wenigstens eine Antriebsmotor und ein zum Verbinden der Welle vorgesehener Befestigungsbereich der Radnabe auf unterschiedlichen Höhen befinden. Eine solche biegeelastische Welle kann zumindest bereichsweise durch ein flexibles Material, wie Gummi und/oder einen biegeelastischen Kunststoff, ausgebildet sein.

Weiter kann der Prüfstand eine Einrichtung, welche eine elektromagnetische Störgröße für ein jeweiliges Kraftfahrzeug erzeugen kann, umfassen. Es hat sich bewährt, wenn die Einrichtung, welche ggf. eine elektromagnetische Störgröße für ein jeweiliges Kraftfahrzeug erzeugen kann, mit einer Steuer- und/oder Regeleinrichtung in Verbindung steht. Auch kann der Prüfstand eine Funktionsüberprüfungseinrichtung besitzen, welche ein als Bestandteil des jeweiligen Kraftfahrzeuges ausgebildetes Drive-by-Wire Lenksystem auf eine Beeinflussung seiner Arbeitsweise aufgrund einer jeweiligen mittels der Einrichtung für das jeweilige Kraftfahrzeug eingebrachten Störgröße überprüfen kann.

In diversen Ausführungsformen kann es sein, dass die Radnabe des Prüfrades mittels der Welle des wenigstens einen Antriebsmotors mit einer vorgegebenen Rotationsfrequenz antreibbar ist und dass die Funktionsüberprüfungseinrichtung im Rahmen der Überprüfung ermitteln kann, ob ein bei einer über das Drive-by-Wire Lenksystem durchgeführten Lenkbewegung herbeigeführter Ist-Lenkeinschlag der am Radträger des Kraftfahrzeuges befestigten Radnabe des mindestens einen Prüfrades einem in Abhängigkeit der jeweiligen vorgegebenen Rotationsfrequenz der Radnabe erwartetem Lenkeinschlag entspricht.

Auch die Funktionsüberprüfungseinrichtung kann ggf. mit der Steuer- und/oder Regeleinrichtung in Verbindung stehen. In diversen weiteren Ausführungsformen kann es sein, dass ein ggf. als Bestandteil des jeweiligen Kraftfahrzeuges ausgebildetes Drive-by-Wire Lenksystem mittels einer Sichtprüfung auf eine Beeinflussung seiner Arbeitsweise aufgrund einer jeweiligen mittels der Einrichtung für das jeweilige Kraftfahrzeug eingebrachten Störgröße überprüft wird. Auch kann eine entsprechende Sensorik vorgesehen sein, über welche die Steuer- und/oder Regeleinrichtung eine Beeinflussung des Drive-by-Wire Lenksystems auf eine Beeinflussung seiner Arbeitsweise aufgrund einer jeweiligen mittels der Einrichtung für das jeweilige Kraftfahrzeug eingebrachten Störgröße überprüfen kann.

Auch kann der Prüfstand eine Sensorik sowie eine Steuer- und/oder Regeleinrichtung umfassen, wobei die Steuer- und/oder Regeleinrichtung unter Zuhilfenahme der Sensorik eine Drehfrequenz von über das Kraftfahrzeug angetriebenen Rädern erkennen kann und wobei vorgesehen ist, dass der Antriebsmotor über die Steuer- und/oder Regeleinrichtung derart ansteuerbar und/oder regelbar ist, dass der Antriebsmotor die Radnabe des Prüfrades mit einer Rotationsfrequenz antreibt, welche Rotationsfrequenz der Drehfrequenz der über das Kraftfahrzeug angetriebenen Räder entspricht.

Somit kann es sein, dass der Prüfstand eine Sensorik sowie eine Steuer- und/oder Regeleinrichtung umfasst, wobei die Steuer- und/oder Regeleinrichtung unter Zuhilfenahme der Sensorik eine Drehfrequenz von über das Kraftfahrzeug angetriebenen Rädern erkennen kann und wobei vorgesehen ist, dass der Antriebsmotor über die Steuer- und/oder Regeleinrichtung derart ansteuerbar und/oder regelbar ist, dass der Antriebsmotor die Radnabe des Prüfrades mit einer Rotationsfrequenz antreibt, welche Rotationsfrequenz synchron zur Drehfrequenz der über das Kraftfahrzeug angetriebenen Räder ausgebildet ist. Die Sensorik kann ggf. Informationen zu einer Drehfrequenz eines Rollenpaares bereitstellen, auf welchem Rollenpaar das Kraftfahrzeug mit seinen hinteren angetriebenen Rädern oder mit seinen vorderen angetriebenen Rädern aufsteht. Die Steuer- und/oder Regeleinrichtung kann ggf. aus den über die Sensorik bereitgestellten Informationen zur Drehfrequenz des Rollenpaares die jeweilige Drehfrequenz der hinteren angetriebenen Räder bzw. der vorderen angetriebenen Räder des Kraftfahrzeuges ableiten.

Hierbei kann es sein, dass die Steuer- und/oder Regeleinrichtung die Rotationsfrequenz der Radnabe des Prüfrades durch Regelung des Antriebsmotors zumindest näherungsweise in Echtzeit an die über die Sensorik erkannte Drehfrequenz der über das Kraftfahrzeug angetriebenen Räder anpassen kann.

Die Erfindung betrifft zudem ein Verfahren zum Durchführen einer Kraftfahrzeugprüfung. Merkmale, welche vorhergehend bereits zu diversen Ausführungsformen des Prüfrades bzw. des Prüfstandes beschrieben wurden, können ebenso bei den nachfolgend beschriebenen Ausführungsformen des erfindungsgemäßen Verfahrens vorgesehen sein, ohne explizit nochmals erwähnt zu werden. Ebenso können nachfolgend zu diversen Ausführungsformen des Verfahrens beschriebene Merkmale bei den vorhergehend bereits beschriebenen Ausführungsformen eines Prüfrades bzw. eines Prüfstandes vorgesehen sein, ohne erneut erwähnt zu werden. Der vorherig bereits beschriebene Prüfstand kann zur Umsetzung der nachfolgend beschriebenen Ausführungsformen des erfindungsgemäßen Verfahrens ausgebildet sein.

Insbesondere kann die Erfindung ein Verfahren zum Durchführen einer Kraftfahrzeugprüfung betreffen, welche Kraftfahrzeuge als Automobile ausgebildet sind. Ein Automobil kann somit genau zwei Vorderräder und genau zwei Hinterräder umfassen. Ein Schritt des Verfahrens sieht einen Austausch mindestens eines Rades des Kraftfahrzeuges bzw. mindestens eines nicht über das Kraftfahrzeug antreibbaren Rades gegen mindestens ein Prüfrad vor, wobei das mindestens eine Rad bzw. das mindestens eine nicht über das Kraftfahrzeug antreibbare Rad vom Kraftfahrzeug abgenommen wird und eine Radnabe des mindestens einen Prüfrades an einem Radträger des Kraftfahrzeuges befestigt wird. Es kann hierbei sein, dass Schraubverbindungen, welche das bis dahin am jeweiligen Radträger des Kraftfahrzeuges befestigte Rad halten, gelöst werden, woraufhin das jeweilige Rad vom jeweiligen Kraftfahrzeug abgenommen wird. Nachfolgend kann das mindestens eine Prüfrad am jeweiligen Radträger des Kraftfahrzeuges mittels der gelösten Schraubverbindungen befestigt bzw. an dem jeweiligen einen Radträger des Kraftfahrzeuges mittels der gelösten Schraubverbindungen angeordnet werden. Es kann hierbei sein, dass der Austausch des mindestens einen Rades des Kraftfahrzeuges bzw. des mindestens einen nicht über das Kraftfahrzeug antriebbaren Rades gegen das mindestens eine Prüfrad händisch vorgenommen wird. Alternativ hierzu kann es sein, dass der Austausch des mindestens einen Rades des Kraftfahrzeuges bzw. des mindestens einen nicht über das Kraftfahrzeug antreibbaren Rades gegen das mindestens eine Prüfrad voll- oder teilautomatisiert über einen Manipulator vorgenommen wird.

Hierbei kann es sein, dass insbesondere beide Vorderräder eines Kraftfahrzeuges jeweils gegen ein Prüfrad ausgetauscht werden, wobei die beiden Vorderräder vom Kraftfahrzeug abgenommen werden und eine Radnabe eines jeweiligen Prüfrades an einem jeweiligen Radträger des Kraftfahrzeuges, welcher bis dahin das jeweilige Vorderrad getragen hat, befestigt wird. Solche Ausführungsformen haben sich insbesondere dann bewährt, sofern bei dem jeweiligen Kraftfahrzeug ausschließlich die beiden Hinterräder bzw. das hintere Radpaar als Antriebsräder ausgebildet sind.

Auch kann es sein, dass beide Hinterräder eines Kraftfahrzeuges jeweils gegen ein Prüfrad ausgetauscht werden, wobei die beiden Hinterräder vom Kraftfahrzeug abgenommen werden und eine Radnabe eines jeweiligen Prüfrades an einem jeweiligen Radträger des Kraftfahrzeuges, welcher bis dahin das jeweilige Hinterrad getragen hat, befestigt wird. Solche Ausführungsformen haben sich insbesondere dann bewährt, sofern bei dem jeweiligen Kraftfahrzeug ausschließlich die beiden Vorderräder bzw. das vordere Radpaar als Antriebsräder ausgebildet sind.

Es ist vorgesehen, dass eine Lenkbewegung des Kraftfahrzeuges durchgeführt wird, wobei die am Radträger des Kraftfahrzeuges befestigte Radnabe des Prüfrades um eine aufrechte und vorzugsweise vertikal orientierte Achse relativ zur Radfelge gedreht wird und wobei überprüft wird, ob die durchgeführte Lenkbewegung vorgegebene Soll-Kriterien erfüllt. Zu solchen vorgegebenen Soll-Kriterien können beispielsweise ein vorgegebener Lenkeinschlag der Vorderräder und/oder eine Verzögerung zwischen einer über ein Lenkrad herbeigeführten Lenkbewegung und dem ggf. vorhandenen Lenkeinschlag der Vorderräder zählen.

Alternativ oder ergänzend hierzu kann es sein, dass die am Radträger des Kraftfahrzeuges befestigte Radnabe des Prüfrades mittels eines Antriebsmotors eines Prüfstandes um eine horizontal orientierte Achse relativ zur Radfelge rotierend bewegt wird und wobei während der rotierenden Bewegung überprüft wird, ob bestimmte Funktionen des Kraftfahrzeuges vorgegebene Soll-Kriterien erfüllen. Solche Soll-Kriterien können beispielsweise durch Geräuschemissionen ausgebildet sein, welche das Fahrzeug während des Betriebes emittiert. Auch können solche Soll-Kriterien durch eine Störausstrahlung ausgebildet sein, welche das jeweilige Fahrzeug während seines Betriebes abgibt. Bewährt hat es sich auch, wenn die vorgegebenen Soll-Kriterien sich auf eine nachfolgend beschriebene und über ein Drive-by-Wire-System des Kraftfahrzeuges durchgeführte Lenkbewegung beziehen, bei welcher die am Radträger des Kraftfahrzeuges befestigte Radnabe des Prüfrades zudem um eine aufrechte und vorzugsweise vertikal orientierte Achse relativ zur Radfelge gedreht wird.

Somit kann es sein, dass eine elektromagnetische Störgröße für das Kraftfahrzeug erzeugt wird. Weiter kann hierbei überprüft werden, ob eine über ein Drive-by-Wire-System des Kraftfahrzeuges durchgeführte Lenkbewegung, bei welcher die am Radträger des Kraftfahrzeuges befestigte Radnabe des Prüfrades um eine aufrechte und vorzugsweise vertikal orientierte Achse relativ zur Radfelge gedreht wird, durch die elektromagnetische Störgröße beeinflusst wird. Beispielsweise kann im Rahmen einer solchen Überprüfung festgestellt werden, ob ein Drehwinkel bzw. ein Lenkeinschalg der am Radträger des Kraftfahrzeuges befestigten Radnabe einem erwarteten Drehwinkel entspricht, welcher mit der jeweiligen durchgeführten Lenkbewegung in Zusammenhang steht bzw. für die jeweilige durchgeführte Lenkbewegung erwartet wird.

Seit jüngerer Zeit werden zudem Fahrzeuge zumindest teilautonom betrieben, wobei entsprechende als Bestandteil des jeweiligen Kraftfahrzeuges ausgebildete Steuereinrichtung hierbei selbständig eine Lenkbewegung für das jeweilige Kraftfahrzeug herbeiführen. Auch eine korrekte bzw. zuverlässige Arbeitsweise einer zum autonomen oder teilautonomen Lenken eines jeweiligen Kraftfahrzeuges vorgesehenen Steuereinrichtung, kann in diversen Ausführungsformen des erfindungsgemäßen Verfahrens sowie mit diversen Ausführungsformen des erfindungsgemäßen Prüfstandes ggf. überprüft werden.

Es kann hierbei sein, dass eine elektromagnetische Störgröße für das Kraftfahrzeug erzeugt wird. Weiter kann hierbei überprüft werden, ob eine über ein Drive-by-Wire-System des Kraftfahrzeuges mittels seiner zum teilautonomen oder autonomen Führen des Kraftfahrzeuges vorgesehenen Steuereinrichtung durchgeführte Lenkbewegung, bei welcher die am Radträger des Kraftfahrzeuges befestigte Radnabe des mindestens einen Prüfrades um eine aufrechte und vorzugsweise vertikal orientierte Achse relativ zur Radfelge gedreht wird, durch die elektromagnetische Störgröße beeinflusst wird.

Bei einem Drive-by-Wire System kann es auch der Fall sein, dass ein Radeinschlag bei hoher Geschwindigkeit des Kraftfahrzeuges gegenüber einem Radeinschlag bei niedriger Geschwindigkeit des Kraftfahrzeuges geringer ausgebildet wird. Denkbar ist daher, dass in diversen Ausführungsformen des erfindungsgemäßen Verfahrens und bei diversen Ausführungsformen des erfindungsgemäßen Prüstandes überprüft wird, ob eine über ein Drive-by-Wire Lenksystem des Kraftfahrzeuges durchgeführte Lenkbewegung zu einem Lenkeinschlag der am jeweiligen Radträger des jeweiligen Kraftfahrzeuges angeordneten Radnabe des jeweiligen Prüfrades entspricht, welcher Lenkeinschlag in Abhängigkeit der jeweiligen Ist-Drehfrequenz der am jeweiligen Radträger des jeweiligen Kraftfahrzeuges angeordneten Radnabe des jeweiligen Prüfrades erwartet wird.

Somit kann es bei diversen Ausführungsformen des erfindungsgemäßen Prüfstandes sowie bei diversen Ausführungsformen des nachfolgend noch beschriebenen erfindungsgemäßen Verfahrens jeweils sein, dass die am Radträger des Kraftfahrzeuges befestigte Radnabe mittels eines Antriebsmotors eines Prüfstandes um eine horizontal orientierte Achse relativ zur Radfelge mit einer bekannten oder ermittelten Rotationsfrequenz rotierend bewegt wird. Im Rahmen der vorherig bereits erwähnten Überprüfung kann zudem festgestellt werden, ob ein bei einer durchgeführten Lenkbewegung in Abhängigkeit der jeweiligen bekannten oder ermittelten Rotationsfrequenz erwarteter Lenkeinschlag der am Radträger des Kraftfahrzeuges befestigten Radnabe des mindestens einen Prüfrades einem Ist-Lenkeinschlag entspricht, mit welchem die am Radträger des Kraftfahrzeuges befestigte Radnabe des Prüfrades bei der durchgeführten Lenkbewegung relativ zur Radfelge gedreht wird.

Es kann zudem sein, dass eine elektromagnetische Störgröße für das Kraftfahrzeug erzeugt wird, wobei hierbei überprüft wird, ob eine über ein Drive-by-Wire-System des Kraftfahrzeuges durchgeführte Lenkbewegung, bei welcher die am Radträger des Kraftfahrzeuges befestigte Radnabe des Prüfrades um eine aufrechte und vorzugsweise vertikal orientierte Achse relativ zur Radfelge gedreht wird, durch elektromagnetische Strahlung beeinflusst wird, während zeitgleich die am Radträger des Kraftfahrzeuges befestigte Radnabe des Prüfrades mittels eines Antriebsmotors des Prüfstandes um eine horizontal orientierte Achse relativ zur Radfelge rotierend bewegt wird.

Denkbar ist auch, dass die am Radträger des Kraftfahrzeuges befestigte Radnabe des Prüfrades mittels eines Antriebsmotors eines Prüfstandes über eine Kardangelenkwelle oder die vorherig bereits erwähnte biegeelastische Welle um eine horizontal orientierte Achse relativ zur Radfelge rotierend bewegt wird. Solche Ausführungsformen sind vorteilhaft, da eine Kardangelenkwelle oder eine biegeelastische Welle an Prüfrädern, welche ggf. unterschiedliche Durchmesser besitzen, auf einfache Art und Weise befestigt werden kann.

Es kann sein, dass das Kraftfahrzeug mit angetriebenen Rädern, welche ggf. durch ein vorderes Radpaar oder durch ein hinteres Radpaar ausgebildet sein können, auf ein Rollenpaar auffährt und hierauf folgend ein Antriebsmoment auf das Rollenpaar überträgt. Weiter kann hierbei eine Drehfrequenz der angetriebenen Räder des Kraftfahrzeuges ggf. unter Zuhilfenahme einer Steuer- und/oder Regeleinrichtung sensorisch erfasst bzw. festgestellt werden und die am Radträger des Kraftfahrzeuges befestigte Radnabe des Prüfrades mittels des Antriebsmotors mit einer Rotationsfrequenz rotierend bewegt werden, welche Rotationsfrequenz der Drehfrequenz der angetriebenen Räder des Kraftfahrzeuges entspricht. Es kann eine Steuer- und/oder Regeleinrichtung vorgesehen sein, welche aus der Drehfrequenz des Rollenpaares eine Drehfrequenz der angetriebenen Räder ableitet.

Vorstellbar ist auch, dass die Rotationsfrequenz der Radnabe des Prüfrades durch Regelung des Antriebsmotors zumindest näherungsweise in Echtzeit an die sensorisch erfasste bzw. an die sensorisch festgestellte Drehfrequenz der angetriebenen Räder angepasst wird. Für eine solche zumindest näherungsweise in Echtzeit durchgeführte Anpassung der Rotationsfrequenz der Radnabe des Prüfrades durch Regelung des Antriebsmotors kann weiterhin eine computergestützte Regelungseinrichtung vorgesehen sein, welche hierzu mit dem Antriebsmotor in Verbindung steht.

Im Folgenden sollen Ausführungsbeispiele die Erfindung und ihre Vorteile anhand der beigefügten Figuren näher erläutern. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind.
Figur 1 zeigt eine schematische Perspektivansicht einer Ausführungsform eines erfindungsgemäßen Prüfstandes und verdeutlicht einzelne Schritte, wie sie bei diversen Ausführungsformen eines erfindungsgemäßen Verfahrens vorgesehen sein können;
Figur 2 zeigt einzelne Details der Ausführungsform eines Prüfstandes nach Figur 1 und zeigt zudem einen schematischen Querschnitt durch eine Ausführungsform eines erfindungsgemäßen Prüfrades;
Figur 3 zeigt im Flussdiagramm einzelne Schritte, wie sie bei diversen Ausführungsformen des erfindungsgemäßen Verfahrens vorgesehen sein können.

Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar.

Es sei an dieser Stelle ausdrücklich erwähnt, dass alle Aspekte und Ausführungsvarianten, die im Zusammenhang mit dem erfindungsgemäßen Prüfrad bzw. Prüfstand erläutert wurden, gleichermaßen Teilaspekte des erfindungsgemäßen Verfahrens betreffen oder sein können. Wenn daher an einer Stelle bei der Beschreibung oder auch bei den Anspruchsdefinitionen zum erfindungsgemäßen Prüfrad oder Prüfstand von bestimmten Aspekten und/oder Zusammenhängen und/oder Wirkungen die Rede ist, so gilt dies gleichermaßen für das erfindungsgemäße Verfahren. In umgekehrter Weise gilt dasselbe, so dass auch alle Aspekte und Ausführungsvarianten, die im Zusammenhang mit dem erfindungsgemäßen Verfahren erläutert wurden, gleichermaßen Teilaspekte des erfindungsgemäßen Prüfrades bzw. Prüfstandes betreffen oder sein können. Wenn daher an einer Stelle bei der Beschreibung oder auch bei den Anspruchsdefinitionen zum erfindungsgemäßen Verfahren von bestimmten Aspekten und/oder Zusammenhängen und/oder Wirkungen die Rede ist, so gilt dies gleichermaßen für den erfindungsgemäßen Prüfstand bzw. für das erfindungsgemäße Prüfrad. Der Prüfstand kann zum Durchführen der beschriebenen Ausführungsformen des erfindungsgemäßen Verfahrens ausgebildet bzw. hierzu angepasst sein.

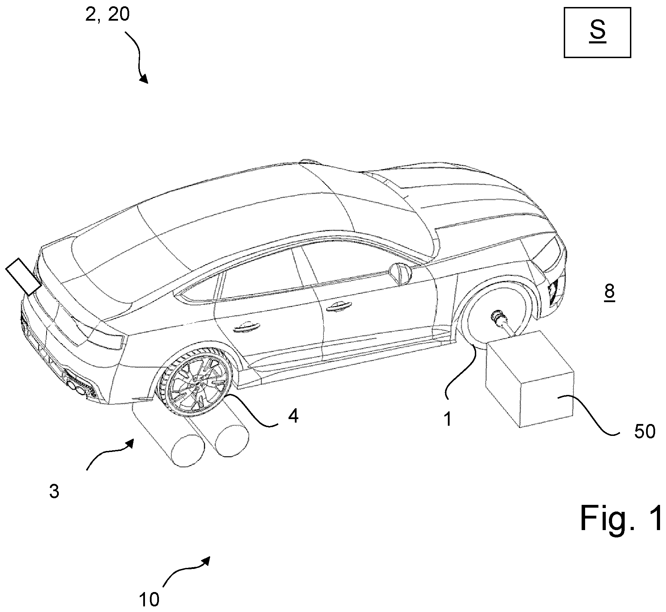

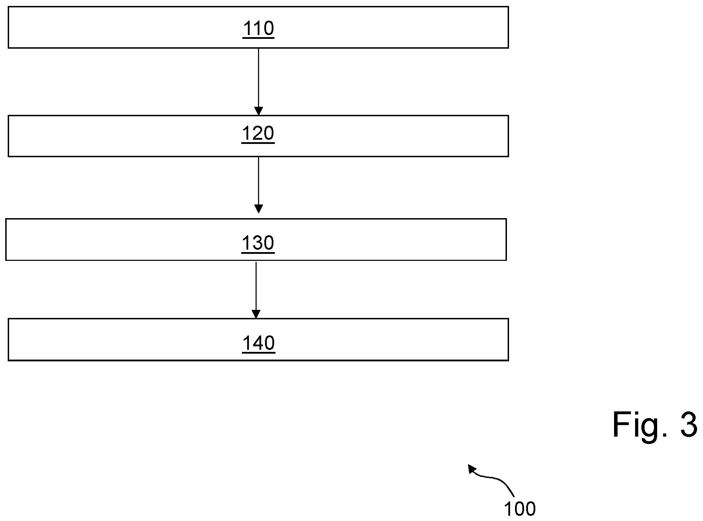

Figur 1 zeigt eine schematische Perspektivansicht einer Ausführungsform eines erfindungsgemäßen Prüfstandes 10 und verdeutlicht einzelne Schritte, wie sie bei diversen Ausführungsformen eines erfindungsgemäßen Verfahrens 100 (vgl. Figur 3) vorgesehen sein können.

Mittels eines Prüfstandes 10, wie er in Figur 1 dargestellt ist, werden Kraftfahrzeuge 2 bzw. Personenkraftfahrzeuge 20 auf ihre elektromagnetische Verträglichkeit überprüft. Da seit längerer Zeit eine Vielzahl von Systemen bei einem Kraftfahrzeug 2 durch elektronische Komponenten ersetzt wird und diese Systeme selbst elektromagnetische Strahlung aussenden, ist es zum sicheren Betrieb des Kraftfahrzeuges 2 erforderlich, dass diese elektronischen Komponenten auch bei einer Vielzahl elektronischer Störgrößen sicher und ohne Probleme funktionieren. So existieren auch gesetzliche Anforderungen, welche im Hinblick auf eine Produkthaftung vorschreiben, dass elektronische Komponenten, wie beispielsweise ein Drive-by-Wire-Lenksystem, nicht durch elektromagnetische Strahlung in ihrer Funktion beeinträchtigt werden dürfen. Dieser Anforderung kommt in jüngerer Zeit eine größere Bedeutung zu, da zahlreiche Systeme, welche bis dato auf mechanische Art und Weise arbeiteten, nun elektronisch angesteuert werden sollen. Das vorherig bereits erwähnte Drive-by-Wire-Lenksystem stellt ein solches System dar. Ex existieren beispielsweise Fahrzeuge, welche über ein autonomes Fahrsystem verfügen und ein Drive-by-Wire Lenksystem steuern.

Bei einem Drive-by-Wire Lenksystem wird auf eine mechanische Verbindung zwischen einem Lenkrad und den Rädern verzichtet. Hingegen wird eine Bewegung eines Lenkrades sensorisch überwacht und ein Aktor angesteuert, sofern das Lenkrad bewegt bzw. gedreht wird. Verfügt das Fahrzeug über ein autonomes Fahrsystem, so kann es ggf. sein, dass das autonome Fahrsystem eine Lenkbewegung des Fahrzeuges über ein solches Drive-by-Wire Lenksystem vornimmt. Der Aktor schwenkt sodann die vorderen Räder eines Kraftfahrzeuges 2 entsprechend der durchgeführten Lenkbewegung des Lenkrades oder entsprechend der Vorgabe des autonomen Fahrsystems mit einem hierauf abgestimmten Lenkeinschlag.

Ein Prüfstand 10, wie er in Figur 1 dargestellt ist, kann in einer gegenüber elektromagnetischen Strahlung abgeschirmten Halle angeordnet werden, um unerwünschte elektromagnetische Strahlungen vom Prüfstand 10 fernzuhalten und ein plausibles Ergebnis zu erhalten, ob bzw. inwiefern elektronische Komponenten bei einer elektromagnetischen Störgröße zuverlässig arbeiten.

Bei Kraftfahrzeugen 2 bzw. Personenkraftfahrzeugen 20, die eine Vielzahl an elektronischen System besitzen, ist es im Rahmen einer Überprüfung erforderlich, dass das Kraftfahrzeug 2 gefahren wird bzw. dass die Räder des Kraftfahrzeuges 2 bewegt werden, da eine solche Bewegung in der Regel durch mehrere als Bestandteil des Kraftfahrzeuges 2 ausgebildete Sensoren erkannt wird und die elektronischen Systeme erst bei einer Bewegung des Kraftfahrzeuges 2 zu arbeiten beginnen. Der Prüfstand 10 verfügt daher über ein Rollenpaar 3, auf welches Rollenpaar 3 das Kraftfahrzeug 2 mit seinen angetriebenen Rädern bzw. vorliegend mit seinen Hinterrädern 4 auffährt. Sofern die Hinterräder 4 angetrieben werden, wird ein jeweiliges Antriebsmoment der Hinterräder 4 über das Rollenpaar 3 aufgenommen, wobei das Rollenpaar 3 drehend bewegt wird und das Kraftfahrzeug 2 in seiner Position verbleibt. Sofern ein Kraftfahrzeug 2 mittels des Prüfstandes 10 überprüft werden soll, dessen Vorderräder angetrieben werden, fährt das Kraftfahrzeug 2 mit seinen Vorderrädern auf das Rollenpaar 3 auf. In diesem Fall können die jeweiligen nicht über das Kraftfahrzeug 2 angetriebenen Hinterräder 4 jeweils durch ein Prüfrad 1 ausgetauscht werden.

Bei Personenkraftfahrzeugen 20, welche eine Vielzahl elektronischer Komponenten besitzen, ergibt sich in der Praxis das Problem, dass ggf. auch die Vorderräder bzw. die jeweiligen nicht angetriebenen Räder zur Überprüfung des Kraftfahrzeuges 2 drehend bewegt werden müssen, da ggf. elektronische System erst bei einer solchen Bewegung zu arbeiten beginnen. Ein weiteres Problem kann sich ergeben, wenn ein Drive-by-Wire Lenksystem des Kraftfahrzeuges 2 auf seine ordnungsgemäße Funktion hin überprüft werden soll, da hierzu bis dato die Vorderräder gelenkt werden müssen und das Kraftfahrzeug 2 bei einer solchen Bewegung ggf. mit seinen Rädern das Rollenpaar 3 ungewollt verlassen kann. Sofern das Kraftfahrzeug 2 das Rollenpaar 3 verlässt während seine Hinterräder 4 angetrieben werden, besteht ein hohes Sicherheitsrisiko, da die Hinterräder 4 des Kraftfahrzeuges 2 bei Verlassen des Rollenpaares 3 ihr jeweiliges Antriebsmoment unmittelbar auf eine Bodenfläche übertragen und das Kraftfahrzeug 2 sofort unkontrolliert beschleunigt wird.

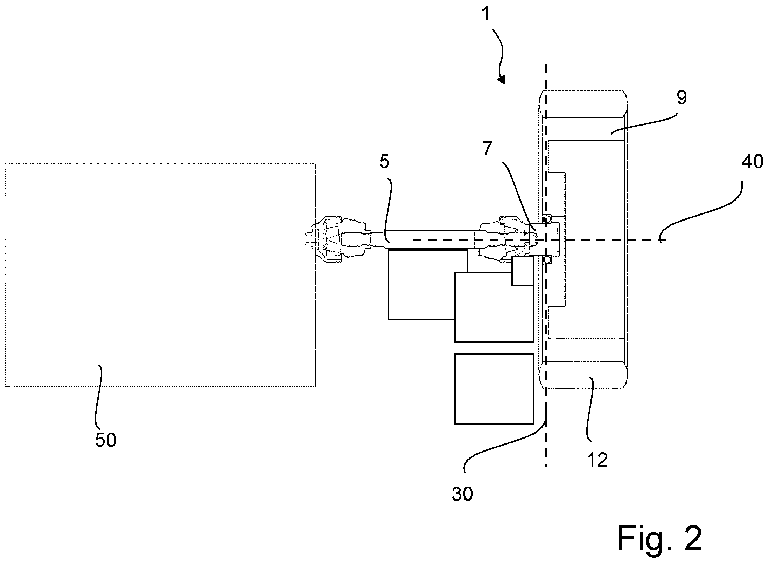

Bei einem Prüfstand 10, wie er in Figur 1 gezeigt ist, sind solche Probleme nicht vorhanden. So umfasst der Prüfstand 10 zwei Prüfräder 1. Bevor eine Überprüfung des Kraftfahrzeuges 2 erfolgt, werden die in den Figuren nicht mit dargestellten Vorderräder des Kraftfahrzeuges 2 gegen Prüfräder 1 ausgetauscht. Hierzu werden zunächst die Vorderräder des Kraftfahrzeuges 2 vom Kraftfahrzeug 2 abgenommen. Sodann wird eine jeweilige Radnabe 7 (vgl. Figur 2) eines jeweiligen Prüfrades 1 an einem jeweiligen Radträger des Kraftfahrzeuges 2 befestigt. Hierauf steht das Kraftfahrzeug 2 mit den Prüfrädern 1, welche am Kraftfahrzeug 2 befestigt sind, auf einer Bodenfläche 8 bzw. ebenen Fläche auf.

Die Radnabe 7 des Kraftfahrzeuges 2 wird sodann mit einer Welle 5 (vgl. Figur 2) verbunden, welche als Kardangelenkwelle 5' ausgebildet ist. Die Welle 5 bzw. die Kardangelenkwelle 5' wird von einem Antriebsmotor des Prüfstandes 10 angetrieben, welcher Antriebsmotor in einem gegen elektromagnetische Strahlung abgeschirmten Gehäuse 50 angeordnet ist. Der Aufbau des Prüfrades 1 ist in der Schnittdarstellung nach Figur 2 zu erkennen.

Das Prüfrad 1 besitzt einen Radmantel 12, welcher an einer Radfelge 9 angeordnet ist. Weiter umfasst das Prüfrad 1 eine Radnabe 7, welcher zur Befestigung an einem Radträger des Kraftfahrzeuges 2 ausgebildet ist. Die Radnabe 7 ist derart mit der Radfelge 9 des Prüfrades 1 verbunden, dass die Radnabe 7 beistehendem Prüfrad 1 relativ zur Radfelge 9 um eine vertikal orientierte Achse 30 gedreht werden kann. Hierdurch kann das Kraftfahrzeug 2 eine Lenkbewegung durchführen, wobei Radfelge 9 und Radmangel 12 hierbei in ihrer Position verbleiben und lediglich die am Radträger angeordnete Radnabe 7 bei der Lenkbewegung verschwenkt wird. Es besteht somit kein Risiko, dass das Kraftfahrzeug 2 bei einer Lenkbewegung ungewollt horizontal verlagert wird.

Wie vorhergehend bereits erwähnt, wird die Radnabe 7 zudem über den im Gehäuse 50 aufgenommenen Antriebsmotor rotierend bewegt. Bei dem Prüfrad 1 ist hierbei vorgesehen, dass die Radnabe 7 relativ zur Radfelge 9 sowie relativ zum Radmantel 12 um die horizontal orientierte Achse 40 rotierend bewegt werden kann. Zwischen der Radnabe 7 und der Radfelge 9 ist daher ein Freilauf ausgebildet. Sofern das Kraftfahrzeug 2 elektronische Komponenten besitzt, die erst bei rotierendem Antrieb der Vorderräder des Kraftfahrzeuges 2 zu arbeiten beginnen, ist es mittels des mit dem Radträger verbundenen Prüfrades 1 möglich, dass die elektronischen Komponenten dem rotierenden Antrieb der Radnabe 7 eine Fahrtbewegung des Kraftfahrzeuges 2 zuordnen und hierdurch ihre Arbeit aufnehmen.

Um aussagekräftige Prüfergebnisse über das Verhalten des Kraftfahrzeuges 2 zu erhalten, hat es sich bewährt, wenn mittels des Prüfstandes 10 möglichst realistische Fahrbewegungen für das Kraftfahrzeug 2 simuliert werden. Hierbei kann es sein, dass die Steuer- und/oder Regeleinrichtung S mit einer Sensorik in Verbindung steht, über welche Sensorik die Steuer- und/oder Regeleinrichtung S eine Drehfrequenz der Hinterräder 4 des Kraftfahrzeuges 2 erkennen kann. Beispielsweise kann eine solche Sensorik in das Rollenpaar 3 integriert sein, wobei die Steuer- und/oder Regeleinrichtung S aus einer Drehfrequenz des Rollenpaares 3 auf die jeweilige Drehfrequenz der Hinterräder 4 schließt. Darüber hinaus eignen sich zur Erkennung der Drehfrequenz der Hinterräder 4 weitere Sensoren bzw. Drehzahlsensoren, die ggf. mit der Steuer- und/oder Regeleinrichtung S in Verbindung stehen können.

Auch der Antriebsmotor, welcher im Gehäuse 50 aufgenommen ist, steht mit der Steuer- und/oder Regeleinrichtung S in Verbindung. Die Steuer- und/oder Regeleinrichtung S kann den Antriebsmotor hierbei derart ansteuern bzw. regeln, dass die Rotationsfrequenz der Radnabe 7 der Drehfrequenz der Hinterräder 4 entspricht. Bewährt hat es sich hierbei, wenn die Steuer- und/oder Regeleinrichtung S den Antriebsmotor über den Zeitverlauf regelt. Wird die Drehfrequenz für die Hinterräder 4 erhöht, so kann die Steuer- und/oder Regeleinrichtung S zumindest näherungsweise zeitgleich bzw. in Echtzeit die Rotationsfrequenz für die Radnabe 7 der Prüfräder 1 anheben, welche Radnabe 7 weiterhin mit einem Radträger des Kraftfahrzeuges 2 verbunden ist. Wird die Drehfrequenz für die Hinterräder 4 verringert, so kann die Steuer- und/oder Regeleinrichtung S zumindest näherungsweise zeitgleich bzw. in Echtzeit die Rotationsfrequenz für die Radnabe 7 der Prüfräder 1 verringern, welche Radnabe 7 weiterhin mit einem Radträger des Kraftfahrzeuges 2 verbunden ist.

Die Steuer- und/oder Regeleinrichtung S steht zudem mit einer Einrichtung in Verbindung, welche eine elektromagnetische Störgröße ausgeben kann. Im Zusammenhang mit einer solchen elektromagnetischen Störgröße über die Einrichtung wird überprüft, ob diverse elektronische Systeme des Kraftfahrzeuges 2 durch die Störgröße beeinflusst werden bzw. ob diverse elektronische Systeme des Kraftfahrzeuges 2 bei einer Störgröße weiterhin problemfrei arbeiten. Hierzu können Sensoren vorgesehen sein, welche für eine solche Überprüfung mit der Steuer- und/oder Regeleinrichtung S verbunden sind. Auch können diverse Funktionen mittels einer Sichtprüfung überprüft werden. Um die Arbeitsweise des Drive-by-Wire-Systems zu überprüfen, führt das Kraftfahrzeug 2 eine Lenkbewegung aus, wobei die Radnabe 7 relativ zur Radfelge 9 gedreht wird. Das Kraftfahrzeug 2 befindet sich hierbei weiterhin mit seinen Hinterrädern 9 auf dem Rollenpaar 3.

Figur 3 zeigt im Flussdiagramm einzelne Schritte, wie sie bei diversen Ausführungsformen des erfindungsgemäßen Verfahrens 100 vorgesehen sein können. Im Rahmen eines ersten Verfahrensschrittes 110 wird ein Kraftfahrzeug 2 mit seinen Hinterrädern 4 auf ein Rollenpaar 3 eines Prüfstandes 10 gefahren.

Im Verfahrensschritt 120 werden sodann die Vorderräder des Kraftfahrzeuges 2 gegen Prüfräder 1 ausgetauscht, wobei die Vorderräder vom Kraftfahrzeug 2 abgenommen werden und eine jeweilige Radnabe 7 des jeweiligen Prüfrades 1 an einem jeweiligen Radträger befestigt wird, an welchem jeweiligen Radträger bis dahin ein jeweiliges Vorderrad angeordnet gewesen ist.

Im Verfahrensschritt 130, welcher auf den Verfahrensschritt 120 folgt, wird die am Radträger befestigte Radnabe 7 des Prüfrades 1 mittels eines Antriebsmotors eines Prüfstandes 10 um eine horizontal orientierte Achse relativ zur Radfelge 9 gedreht. Die Rotationsfrequenz der Radnabe 7 entspricht hierbei einer Drehfrequenz der Hinterräder 4, welche Hinterräder 4 hierbei weiterhin auf dem Rollenpaar 3 aufstehen.

Im Verfahrensschritt 140 wird eine Lenkbewegung des Kraftfahrzeuges 2 durchgeführt. Hierbei werden die an den Radträgern befestigten Radnaben 7 der Prüfräder 1 um eine vertikal orientierte Achse 30 relativ zur Radfelge 9 gedreht. Zudem wird im Verfahrensschritt 140 überprüft, ob die durchgeführte Lenkbewegung vorgegebene Soll-Kriterien erfüllt. Die Lenkbewegung erfolgt hierbei über ein als Bestandteil des Kraftfahrzeuges 2 ausgebildetes Drive-by-Wire Lenksystem.

Wenn auch im Zusammenhang der Figuren generell von "schematischen" Darstellungen und Ansichten die Rede ist, so ist damit keineswegs gemeint, dass die Figurendarstellungen und deren Beschreibung hinsichtlich der Offenbarung der Erfindung von untergeordneter Bedeutung sein sollen. Der Fachmann ist durchaus in der Lage, aus den schematisch und abstrakt gezeichneten Darstellungen genug an Informationen zu entnehmen, die ihm das Verständnis der Erfindung erleichtern, ohne dass er etwa aus den gezeichneten und möglicherweise nicht exakt maßstabsgerechten Größenverhältnisse oder anderer gezeichneter Elemente in irgendeiner Weise in seinem Verständnis beeinträchtigt wäre. Die Figuren ermöglichen es dem Fachmann als Leser somit, anhand der konkreter erläuterten Umsetzungen des erfindungsgemäßen Verfahrens und der konkreter erläuterten Funktionsweise des erfindungsgemäßen Prüfrades bzw. Prüfstandes ein besseres Verständnis für den in den Ansprüchen sowie im allgemeinen Teil der Beschreibung allgemeiner und/oder abstrakter formulierten Erfindungsgedanken abzuleiten, wobei der Umfang der beanspruchten Erfindung durch die beigefügten Ansprüche definiert ist.

### Bezugszeichenliste

- 1: Prüfrad
- 2: Kraftfahrzeug
- 3: Rollenpaar
- 4: Hinterrad
- 5: Welle
- 5': Kardangelenkwelle
- 7: Radnabe
- 8: Bodenfläche
- 9: Radfelge
- 12: Radmantel
- 20: Personenkraftfahrzeug
- 30: Vertikal orientierte Achse
- 40: Horizontal orientierte Achse
- 50: Gehäuse
- 100: Verfahren
- 110: Erster Verfahrensschritt
- 120: Zweiter Verfahrensschritt
- S: Steuer- und/oder Regeleinrichtung

## Patentansprüche

1. Prüfrad (1) für ein Kraftfahrzeug (2), umfassend
- eine Radfelge (9) sowie
- eine Radnabe (7), welche Radnabe (7) zur Befestigung an einem Radträger eines Kraftfahrzeuges (1) ausgebildet ist, das Prüfrad (1) **dadurch gekennzeichnet, dass**
die Radnabe (7) derart mit der Radfelge (9) des Prüfrades (1) in Verbindung steht, dass die Radnabe (7) bei stehendem Prüfrad (1) relativ zur Radfelge (9) um eine aufrechte und vorzugsweise vertikal orientierte Achse (30) gedreht werden kann.

2. Prüfrad (1) nach Anspruch 1, bei welchem die Radnabe (7) über ein Gleit- oder Wälzlager derart mit der Radfelge (9) in Verbindung steht, dass
- die Radnabe (7) bei stehendem Prüfrad (1) relativ zur Radfelge (9) um eine aufrechte und vorzugsweise vertikal orientierte Achse (30) gedreht werden kann und/oder derart, dass
- die Radnabe (7) bei stehendem Prüfrad (1) relativ zur Radfelge (9) um eine horizontal orientierte Achse (40) rotieren kann, wobei die Radnabe (7) mit einer Welle (5) eines als Bestandteil eines Prüfstandes (10) ausgebildeten Antriebsmotors verbindbar ist.

3. Prüfstand (10) für Kraftfahrzeuge (2), umfassend
- mindestens ein Prüfrad (1) nach Anspruch 1 oder Anspruch 2, welches über seine Radnabe (7) an einem Radträger eines Kraftfahrzeuges (2) befestigt werden kann und dessen Radnabe (7) derart mit der Radfelge (9) in Verbindung steht, dass die Radnabe (7) bei stehendem Prüfrad (1) relativ zur Radfelge (9) um eine horizontal orientierte Achse (40) rotieren kann, wobei die Radnabe (7) mit einer Welle (5) eines Antriebsmotors des Prüfstandes (10) verbindbar ist sowie
- wenigstens einen Antriebsmotor mit einer Welle (5), welche Welle (5) mit der Radnabe (7) des Prüfrades (1) verbindbar ist und welche Welle (5) die Radnabe (7) des Prüfrades (1) rotierend antreiben kann.

4. Prüfstand nach Anspruch 3, bei welchem die Welle (5) als Kardangelenkwelle (5') ausgebildet ist.

5. Prüfstand nach Anspruch 3 oder Anspruch 4, bei welchem ein zum Abschirmen gegen elektromagnetische Strahlung ausgebildetes Gehäuse (50) vorgesehen ist, in welchem zum Abschirmen gegen elektromagnetische Strahlung ausgebildeten Gehäuse (50) der wenigstens eine Antriebsmotor aufgenommen ist und/oder bei welchem der wenigstens eine Antriebsmotor in ein elektromagnetische Strahlung absorbierendes Material eingebettet ist.

6. Prüfstand nach einem der Ansprüche 3 bis 5, umfassend
- eine Einrichtung, welche eine elektromagnetische Störgröße für ein jeweiliges Kraftfahrzeug (2) erzeugen kann sowie
- eine Funktionsüberprüfungseinrichtung, welche ein als Bestandteil des jeweiligen Kraftfahrzeuges (2) ausgebildetes Drive-by-Wire-Lenksystem auf eine Beeinflussung seiner Arbeitsweise aufgrund einer jeweiligen mittels der Einrichtung für das jeweilige Kraftfahrzeug (2) eingebrachten Störgröße überprüfen kann.

7. Prüfstand nach Anspruch 6, bei welchem die Radnabe (7) des Prüfrades (1) mittels der Welle (5) des wenigstens einen Antriebsmotors mit einer vorgegebenen Rotationsfrequenz antreibbar ist und bei welchem die Funktionsüberprüfungseinrichtung im Rahmen der Überprüfung ermitteln kann, ob ein bei einer über das Drive-by-Wire Lenksystem durchgeführten Lenkbewegung herbeigeführter Ist-Lenkeinschlag der am Radträger des Kraftfahrzeuges (2) befestigten Radnabe (7) des mindestens einen Prüfrades (1) einem in Abhängigkeit der jeweiligen vorgegebenen Rotationsfrequenz der Radnabe (7) erwartetem Lenkeinschlag entspricht.

8. Prüfstand nach einem der Ansprüche 3 bis 7, umfassend
- eine Sensorik sowie eine Steuer- und/oder Regeleinrichtung (S), wobei die Steuerund/oder Regeleinrichtung (S) unter Zuhilfenahme der Sensorik eine Drehfrequenz von über das Kraftfahrzeug (2) angetriebenen Rädern erkennen kann und wobei vorgesehen ist, dass der Antriebsmotor über die Steuer- und/oder Regeleinrichtung (S) derart ansteuerbar und/oder regelbar ist, dass der Antriebsmotor die Radnabe (7) des Prüfrades (1) mit einer Rotationsfrequenz antreibt, welche Rotationsfrequenz der Drehfrequenz der über das Kraftfahrzeug angetriebenen Räder entspricht.

9. Prüfstand nach Anspruch 8, bei welcher die Steuer- und/oder Regeleinrichtung (S) die Rotationsfrequenz der Radnabe (7) des Prüfrades (1) durch Regelung des Antriebsmotors zumindest näherungsweise in Echtzeit an die über die Sensorik erkannte Drehfrequenz der über das Kraftfahrzeug (2) angetriebenen Räder anpassen kann.

10. Verfahren (100) zum Durchführen einer Kraftfahrzeugprüfung, das Verfahren umfassend folgende Schritte
- Austauschen mindestens eines Rades des Kraftfahrzeuges (2) gegen mindestens ein Prüfrad (1), wobei das mindestens eine Rad vom Kraftfahrzeug (2) abgenommen wird und eine Radnabe (7) des mindestens einen Prüfrades (1) an einem Radträger des Kraftfahrzeuges (2) befestigt wird, wobei vorgesehen ist, dass
- eine Lenkbewegung des Kraftfahrzeuges (2) durchgeführt wird, wobei die am Radträger des Kraftfahrzeuges (2) befestigte Radnabe (7) des Prüfrades (1) um eine aufrechte und vorzugsweise vertikal orientierte Achse (30) relativ zur Radfelge (9) gedreht wird und wobei überprüft wird, ob die durchgeführte Lenkbewegung vorgegebene Soll-Kritieren erfüllt.

11. Verfahren nach Anspruch 10, bei welchem eine elektromagnetische Störgröße für das Kraftfahrzeug (2) erzeugt wird und wobei überprüft wird, ob eine über ein Drive-by-Wire Lenksystem des Kraftfahrzeuges (2) durchgeführte Lenkbewegung, bei welcher die am Radträger des Kraftfahrzeuges (2) befestigte Radnabe (7) des Prüfrades (1) um eine aufrechte und vorzugsweise vertikal orientierte Achse (30) relativ zur Radfelge (9) gedreht wird, durch die elektromagnetische Störgröße beeinflusst wird.

12. Verfahren nach Anspruch 10 oder Anspruch 11, bei welchem die am Radträger des Kraftfahrzeuges (2) befestigte Radnabe (7) des Prüfrades (1) mittels eines Antriebsmotors eines Prüfstandes (10) über eine Kardangelenkwelle (5') um eine horizontal orientierte Achse (40) relativ zur Radfelge (9) rotierend bewegt wird.

13. Verfahren nach einem der Ansprüche 10 bis 12, bei welchem das Kraftfahrzeug (2) mit angetriebenen Rädern auf ein Rollenpaar (3) auffährt, und hierauf folgend ein Antriebsmoment auf das Rollenpaar (3) überträgt und bei welchem Verfahren (100) hierbei eine Drehfrequenz der angetriebenen Räder des Kraftfahrzeuges (2) sensorisch erfasst und/oder sensorisch festgestellt wird und die am Radträger des Kraftfahrzeuges (2) befestigte Radnabe (7) des Prüfrades (1) mittels des Antriebsmotors mit einer Rotationsfrequenz rotierend bewegt wird, welche Rotationsfrequenz der Drehfrequenz der angetriebenen Räder des Kraftfahrzeuges (1) entspricht.

14. Verfahren nach Anspruch 13, bei welchem die Rotationsfrequenz der Radnabe (7) des Prüfrades (1) durch Regelung des Antriebsmotors zumindest näherungsweise in Echtzeit an die sensorisch erfasste Drehfrequenz der angetriebenen Räder angepasst wird.

15. Verfahren nach Anspruch 11, bei welchem die am Radträger des Kraftfahrzeuges (2) befestigte Radnabe (7) mittels eines Antriebsmotors eines Prüfstandes (10) um eine horizontal orientierte Achse (40) relativ zur Radfelge (9) mit einer bekannten oder ermittelten Rotationsfrequenz rotierend bewegt wird und wobei im Rahmen der Überprüfung festgestellt wird, ob ein bei einer durchgeführten Lenkbewegung in Abhängigkeit der jeweiligen bekannten oder ermittelten Rotationsfrequenz erwarteter Lenkeinschlag der am Radträger des Kraftfahrzeuges (2) befestigten Radnabe (7) des mindestens einen Prüfrades (1) einem Ist-Lenkeinschlag entspricht, mit welchem die am Radträger des Kraftfahrzeuges (2) befestigte Radnabe (7) des Prüfrades (1) bei der durchgeführten Lenkbewegung relativ zur Radfelge (9) gedreht wird.

## Claims

1. A test wheel (1) for a motor vehicle (2), comprising
- a wheel rim (9) and
- a wheel hub (7), which wheel hub (7) is designed to be attached to a wheel carrier of a motor vehicle (2), the test wheel (1) being **characterised in that**
the wheel hub (7) is connected to the wheel rim (9) of the test wheel (1) in such a manner that the wheel hub (7) can be rotated relative to the wheel rim (9) about an upright and preferably vertically oriented axis (30) when the test wheel (1) is stationary.

2. The test wheel (1) according to claim 1, in which the wheel hub (7) is connected to the wheel rim (9) via a slide bearing or roller bearing in such a manner that
- the wheel hub (7) can be rotated relative to the wheel rim (9) about an upright and preferably vertically oriented axis (30) when the test wheel (1) is stationary and/or in such a manner that
- the wheel hub (7) can rotate relative to the wheel rim (9) about a horizontally oriented axis (40) when the test wheel (1) is stationary, wherein the wheel hub (7) is connectable to a shaft (5) of a drive motor designed as a component of a test bench (10).

3. A test bench (10) for motor vehicles (2), comprising
- at least one test wheel (1) according to claim 1 or claim 2, which test wheel can be attached via its wheel hub (7) to a wheel carrier of a motor vehicle (2) and the wheel hub (7) of which test wheel is connected to the wheel rim (9) in such a manner that the wheel hub (7) can rotate relative to the wheel rim (9) about a horizontally oriented axis (40) when the test wheel (1) is stationary, wherein the wheel hub (7) is connectable to a shaft (5) of a drive motor of the test bench (10), and
- at least one drive motor with a shaft (5), which shaft (5) is connectable to the wheel hub (7) of the test wheel (1), and which shaft (5) can drive the wheel hub (7) of the test wheel (1) in a rotating manner.

4. The test bench according to claim 3, in which the shaft (5) is designed as a cardan joint shaft (5').

5. The test bench according to claim 3 or claim 4, in which a housing (50) designed to shield against electromagnetic radiation is provided, in which housing (50) designed to shield against electromagnetic radiation the at least one drive motor is accommodated, and/or in which the at least one drive motor is embedded in an electromagnetic radiation-absorbing material.

6. The test bench according to one of the claims 3 to 5, comprising
- a device which can generate an electromagnetic disturbance for each particular motor vehicle (2) and
- a function test device which can check a drive-by-wire steering system designed as a component of the particular motor vehicle (2) for an influence on its mode of operation due to a particular disturbance for the particular motor vehicle (2) introduced by means of the device.

7. The test bench according to claim 6, in which the wheel hub (7) of the test wheel (1) is drivable at a specified rotational speed by means of the shaft (5) of the at least one drive motor, and in which the function test device can determine in the context of the test whether an actual steering angle of the wheel hub (7) of the at least one test wheel (1), which wheel hub (7) is attached to the wheel carrier of the motor vehicle (2), and which actual steering angle is caused by a steering movement performed via the drive-by-wire steering system, corresponds to a steering angle expected based on the particular specified rotational speed of the wheel hub (7).

8. The test bench according to one of the claims 3 to 7, comprising
- a sensor system and a control device and/or regulating device (S), wherein, with the help of the sensor system, the control device and/or regulating device (S) can detect a rotational frequency of wheels being driven by the motor vehicle (2), and wherein it is provided that the drive motor is controllable and/or regulatable via the control device and/or regulating device (S) in such a manner that the drive motor drives the wheel hub (7) of the test wheel (1) at a rotational speed which corresponds to the rotational frequency of the wheels driven via the motor vehicle.

9. The test bench according to claim 8, in which, by regulating the drive motor, the control device and/or regulating device (S) can adapt the rotational speed of the wheel hub (7) of the test wheel (1) at least approximately in real time to the rotational frequency, as detected by the sensor system, of the wheels driven by the motor vehicle (2).

10. A method (100) to carry out a motor vehicle test, the method comprising following steps
- exchanging at least one wheel of the motor vehicle (2) for at least one test wheel (1), wherein the at least one wheel is removed from the motor vehicle (2), and a wheel hub (7) of the at least one test wheel (1) is attached to a wheel carrier of the motor vehicle (2), wherein it is provided that
- a steering movement of the motor vehicle (2) is performed, wherein the wheel hub (7) of the test wheel (1) is rotated relative to the wheel rim (9) about an upright and preferably vertically oriented axis (30) with the wheel hub (7) being attached to the wheel carrier of the motor vehicle (2), and wherein it is checked whether the performed steering movement fulfils specified target criteria.

11. The method according to claim 10, in which an electromagnetic disturbance is generated for the motor vehicle (2), and wherein it is checked whether a steering movement performed via a drive-by-wire steering system of the motor vehicle (2) is influenced by the electromagnetic disturbance, with the performed steering movement causing the wheel hub (7) of the test wheel (1) to be rotated relative to the wheel rim (9) about an upright and preferably vertically oriented axis (30) and the wheel hub (7) being attached to the wheel carrier of the motor vehicle (2).

12. The method according to claim 10 or claim 11, in which the wheel hub (7) of the test wheel (1), which wheel hub (7) is attached to the wheel carrier of the motor vehicle (2), is moved by means of a drive motor of a test bench (10) via a cardan joint shaft (5') in a rotating manner relative to the wheel rim (9) about a horizontally oriented axis (40).

13. The method according to one of the claims 10 to 12, in which the motor vehicle (2) drives with driven wheels onto a roller pair (3) and subsequently transmits a drive torque to the roller pair (3), and in which method (100) a rotational frequency of the driven wheels of the motor vehicle (2) is sensor-detected and/or determined by sensors, and the wheel hub (7) of the test wheel (1), which wheel hub (7) is attached to the wheel carrier of the motor vehicle (2), is moved by means of a drive motor in a rotating manner at a rotational speed which corresponds to the rotational frequency of the driven wheels of the motor vehicle (2).

14. The method according to claim 13, in which, by regulating the drive motor, the rotational speed of the wheel hub (7) of the test wheel (1) is adapted at least approximately in real time to the sensor-detected rotational frequency of the driven wheels.

15. The method according to claim 11, in which the wheel hub (7) attached to the wheel carrier of the motor vehicle (2) is moved by means of a drive motor of a test bench (10) in a rotating manner relative to the wheel rim (9) about a horizontally oriented axis (40) at a known or determined rotational speed, and wherein it is determined in the context of the check whether a steering angle expected based on the particular known or determined rotational speed in a steering movement performed on a wheel hub (7) of the at least one test wheel (1), which wheel hub (7) is attached to the wheel carrier of the motor vehicle (2), corresponds to an actual steering angle with which the wheel hub (7) of the test wheel (1) is rotated relative to the wheel rim (9) in the performed steering movement with the wheel hub (7) being attached to the wheel carrier of the motor vehicle (2).

## Revendications

1. Roue d'essai (1) pour un véhicule automobile (2) comprenant
- une jante (9) ainsi que
- un moyeu (7) qui est conçu pour être fixé à un support de roue d'un véhicule automobile (2), la roue d'essai (1) **caractérisé en ce que**
le moyeu (7) est en liaison avec la jante (9) de la roue d'essai (1) de telle sorte que, lorsque la roue d'essai (1) est debout, le moyeu (7) peut être tourné par rapport à la jante (9) autour d'un axe droit et orienté de préférence verticalement (30).

2. Roue d'essai (1) selon la revendication 1, dans lequel le moyeu (7) est en liaison avec la jante (9) par un palier lisse ou un palier à roulement de telle sorte que,
- lorsque la roue d'essai (1) est debout, le moyeu (7) peut être tourné par rapport à la jante (9) autour d'un axe droit et orienté de préférence verticalement (30), et/ou de telle sorte que,
- lorsque la roue d'essai (1) est debout, le moyeu (7) peut tourner par rapport à la jante (9) autour d'un axe orienté horizontalement (40) et peut être relié à un arbre (5) d'un moteur d'entraînement réalisé comme faisant partie d'un banc d'essai (10).

3. Banc d'essai (10) pour des véhicules automobiles (2) comprenant
- au moins une roue d'essai (1) selon la revendication 1 ou la revendication 2, qui peut être fixé à un support de roue d'un véhicule automobile (2) par son moyeu (7) et dont le moyeu (7) est en liaison avec la jante (9) de telle sorte que, lorsque la roue d'essai (1) est debout, le moyeu (7) peut tourner par rapport à la jante (9) autour d'un axe orienté horizontalement (40) et peut être relié à un arbre (5) d'un moteur d'entraînement d'un banc d'essai (10) ainsi que
- au moins un moteur d'entraînement avec un arbre (5), qui peut être lié avec le moyeu (7) de la roue d'essai (1) and qui peut entraîner le moyeu (7) de la roue d'essai (1) en rotation.

4. Banc d'essai (10) selon la revendication 3, dans lequel l'arbre (5) est conçu en tant qu'arbre à cardan (5').

5. Banc d'essai (10) selon la revendication 3 ou la revendication 4, dans lequel est prévu un boîtier (50) conçu pour protéger contre les rayonnements électromagnétiques, dans lequel l'au moins un moteur d'entraînement est logé pour protéger contre les rayonnements électromagnétiques, et/ou dans lequel l'au moins un moteur d'entraînement est intégré dans un matériau absorbant les rayonnements électromagnétiques.

6. Banc d'essai (10) selon l'une quelconque des revendications 3 à 5 comprenant
- un dispositif capable de générer une perturbation électromagnétique pour un véhicule automobile (2) donné, ainsi que
- un dispositif de contrôle du fonctionnement qui peut vérifier si le fonctionnement d'un système de direction drive-by-wire intégré au véhicule automobile (2) donné est influencé par une grandeur perturbatrice introduite dans le véhicule automobile (2) par l'intermédiaire du dispositif.

7. Banc d'essai (10) selon la revendication 6, dans lequel le moyeu (7) de la roue d'essai (1) peut être entraîné à une fréquence de rotation prédéfinie au moyen de l'arbre (5) d'au moins un moteur d'entraînement et dans lequel le dispositif de contrôle du fonctionnement peut déterminer, dans le cadre du contrôle, si un angle de braquage réel provoqué par un mouvement de direction effectué via le système de direction drive-by-wire du moyeu (7) d'au moins une roue d'essai (1) fixé au support de roue du véhicule automobile (2) correspond à un angle de braquage attendu en fonction de la fréquence de rotation prédéfinie du moyeu de roue (7).

8. Banc d'essai (10) selon l'une quelconque des revendications 3 à 7 comprenant
- un système de capteurs ainsi qu'un dispositif de commande et/ou de régulation (S), dans lequel le dispositif de commande et/ou de régulation (S) peut détecter, à l'aide du système de capteurs, une fréquence de rotation des roues entraînées par le véhicule automobile (2) et dans lequel il est prévu que le moteur d'entraînement puisse être commandé et/ou régulé par le dispositif de commande et/ou de régulation (S) de telle sorte que le moteur d'entraînement entraîne le moyeu (7) de la roue d'essai (1) à une fréquence de rotation qui correspond à la fréquence de rotation des roues entraînées par le véhicule automobile.

9. Banc d'essai (10) selon la revendication 8, dans lequel le dispositif de commande et/ou de régulation (S) peut adapter la fréquence de rotation du moyeu (7) de la roue d'essai (1) à la fréquence de rotation des roues entraînées par le véhicule automobile (2), détectée par les capteurs, au moins approximativement en temps réel, en régulant le moteur d'entraînement.

10. Procédé (100) pour réaliser un contrôle sur un véhicule automobile comprenant les étapes suivantes
- Remplacer au moins une roue du véhicule automobile (2) par au moins une roue d'essai (1), dans lequel l'au moins une roue est démontée du véhicule automobile (2) et un moyeu (7) de l'au moins une roue d'essai (1) est fixé à un support de roue du véhicule automobile (2), dans lequel il est prévu que
- un mouvement de direction du véhicule automobile (2) soit effectué, dans lequel le moyeu (7) de la roue d'essai fixé au support de roue du véhicule automobile (2) est tourné autour d'un axe (30) orienté de manière droite et de préférence verticale par rapport à la jante de roue (9), et dans lequel on vérifie si le mouvement de direction effectué remplit les critères de consigne prédéfinis.

11. Procédé selon la revendication 10, dans lequel une perturbation électromagnétique est générée pour le véhicule automobile (2) et dans lequel on vérifie si un mouvement de direction effectué par un système de direction drive-by-wire du véhicule automobile (2), dans lequel le moyeu (7) de la roue d'essai fixé au support de roue du véhicule automobile (2) est tourné autour d'un axe (30) orienté de manière droite et de préférence verticale par rapport à la jante de roue (9), est influencé par la grandeur de perturbation électromagnétique.

12. Procédé selon la revendication 10 ou la revendication 11, dans lequel le moyeu (7) de la roue d'essai (1), fixé au support de roue du véhicule automobile (2), est mis en rotation autour d'un axe (40) orienté horizontalement par rapport à la jante (9) au moyen d'un moteur d'entraînement d'un banc d'essai (10) via un arbre à cardan (5').

13. Procédé selon l'une quelconque des revendications 10 à 12, dans lequel le véhicule automobile (2) roule avec ses roues motrices sur une paire de rouleaux (3) et transmet ensuite un couple d'entraînement à la paire de rouleaux (3) et dans lequel, dans ce procédé (100), une fréquence de rotation des roues motrices du véhicule automobile (2) est détectée et/ou déterminée par des capteurs et le moyeu (7) de la roue d'essai (1), fixé au support de roue du véhicule automobile (2), est entraîné en rotation au moyen du moteur d'entraînement à une fréquence de rotation qui correspond à la fréquence de rotation des roues motrices du véhicule automobile (2).

14. Procédé selon la revendication 13, dans lequel la fréquence de rotation du moyeu (7) de la roue d'essai (1) est adaptée, au moins approximativement en temps réel, à la fréquence de rotation des roues entraînées détectée par des capteurs, par la régulation du moteur d'entraînement.

15. Procédé selon la revendication 11, dans lequel le moyeu de roue (7) fixé au support de roue du véhicule automobile (2) est mis en rotation autour d'un axe (40) orienté horizontalement par rapport à la jante de roue (9) au moyen d'un moteur d'entraînement d'un banc d'essai (10) à une fréquence de rotation connue ou déterminée, et dans lequel, dans le cadre du contrôle, il est déterminé si, lors d'un mouvement de direction effectué en fonction de la fréquence de rotation connue ou déterminée respective, un angle de braquage attendu du moyeu (7) de l'au moins une roue d'essai (1) fixé au support de roue du véhicule automobile (2) correspond à un angle de braquage réel avec lequel le moyeu (7) de la roue d'essai (1), fixé au support de roue du véhicule automobile (2), est tourné par rapport à la jante de roue (9) lors du mouvement de direction effectué.
